# EUROPÄISCHE PATENTSCHRIFT

(11) **EP 1 706 906 B1**
(45) Veröffentlichungstag und Bekanntmachung des Hinweises auf die Patenterteilung: **03.10.2012**
(21) Anmeldenummer: 05714875.1
(22) Anmeldetag: 19.01.2005
(51) Int. Cl.: H01L 29/06, H01L 29/78, H01L 29/12, H01L 21/336, H01L 29/775, H01L 51/30, H01L 21/335, H01L 51/05, H01L 51/00, B82Y 10/00, B82Y 40/00

(54) **HALBLEITER-LEISTUNGSSCHALTER MIT NANODRÄHTEN SOWIE DAFÜR GEEIGNETES HERSTELLUNGSVERFAHREN**
POWER SEMICONDUCTOR SWITCH HAVING NANOWIRES AND SUITABLE PRODUCTION METHOD THEREFOR
COMMUTATEUR SEMI-CONDUCTEUR DE PUISSANCE AVEC NANOFILS, ET MÉTHODE DE FABRICATION ADAPTÉE À CELUI-CI

(30) Priorität: 22.01.2004 DE 102004003374
(43) Veröffentlichungstag der Anmeldung: 04.10.2006
(73) Patentinhaber: Infineon Technologies AG, 85579 Neubiberg (DE)
(72) Erfinder: KREUPL, Franz, 80802 München (DE); SEIDEL, Robert, 81537 München (DE)
(74) Vertreter: Kottmann, Heinz Dieter
(86) Internationale Anmeldenummer: PCT/DE2005/000069
(87) Internationale Veröffentlichungsnummer: WO 2005/071754

(56) Entgegenhaltungen:
- EP-A- 0 452 950
- WO-A-00/51186
- WO-A-01/57917
- WO-A-2004/040666
- DE-A1- 10 324 752
- US-A- 5 612 563
- US-A1- 2002 163 079
- US-A1- 2003 132 461
- US-A1- 2003 178 617

## Beschreibung

Die Erfindung betrifft einen Halbleiter-Leistungsschalter sowie ein dafür geeignetes Herstellungsverfahren.

Halbleiter-Leistungsschalter finden sich in einer Vielzahl von Geräten in unserer unmittelbaren Umgebung und erweisen dort ihre Dienste, beispielsweise bei der Steuerung und Regelungen von Lasten bis zu mehreren Kilowatt in Lampen, Motoren oder Heizungen. Auch in der Automobiltechnik wird sich in Zukunft immer mehr Leistungselektronik verbergen, um dem Wunsch nach komfortablen, elektronisch regelbaren Einstellmöglichkeiten nachzukommen.

Halbleiter-Leistungsschalter sind mittlerweile in der Lage, Spannungen bis zu 1000 V und Stromdichten bis zu 2000 A/cm² zu verarbeiten. CoolMOS-Leistungsschalter erreichen Stromdichten von 2000 A/cm² und Einschaltwiderstand-Bestwerte von ca. 20 mΩmm². Ähnliche Leistungsdaten lassen sich auch mit anderen Silizium-basierenden Halbleiter-Leistungs-schaltern erreichen. Die Erzielung eines möglichst geringen Einschalt-Widerstandes ist dabei vorrangiges Ziel, da auf diese Weise die auftretenden Verlustleistungen beträchtlich gesenkt werden können.

US 2002/163079 A1, WO00/51186 A, US 2003/132461 A1, EP 0452950 A und US 2003/178617 A1 offenbaren jeweils einen Halbleiterleistungsschalter mit Source, Drain und Gate, bei dem parallele Nanodrähte zwischen Source und Drain vorgesehen sind, die Source und Drain verbinden. Insbesondere ist bei einem in den Figuren 5a-5n in US 2003/0178617 A1 veranschaulichten Halbleiterleistungsschalter ein Bündel von durch isolierende Röhren und Gatedielektrikum umhüllten Nanodrähten vollständig vom Metall der Gateelektrode umgeben, so dass die Nanodrähte bzw. Röhren einzeln das Gatemetall durchsetzen.

Die der Erfindung zugrunde liegende Aufgabe ist, einen Halbleiter-Leistungsschalter anzugeben, mit dem die oben genannten Einschaltwiderstandswerte weiter verbessert werden können.

Zur Lösung dieser Aufgabe stellt die Erfindung einen Halbleiter-Leistungsschalter gemäß Patentanspruch 1 bereit. In Patentanspruch 16 wird ein Verfahren zur Herstellung eines Halbleiter-Leistungsschalters beschrieben. Vorteilhafte Ausgestaltungen bzw. Weiterbildungen des Erfindungsgedankens finden sich in jeweiligen Unteransprüchen.

Durch die Verwendung von Nanodrähten können Halbleiter-Leistungsschalter gewonnen werden, deren flächenbezogener Einschaltwiderstand um Größenordnungen kleiner, und dabei erzielte maximale Stromdichten um Größenordnungen größer sind als bei herkömmlichen Leistungsschaltern: So ist bei einer Nanodrahtdichte von 100 Nanodrähten/µm² der Einschaltwiderstand bereits um den Faktor 20 geringer und die maximale Stromdichte um den Faktor 100 größer als bei herkömmlichen Halbleiter-Leistungsschaltern, beispielsweise Silizium-Leistungsschaltern. Ein weiterer Vorteil des erfindungsgemäßen Halbleiter-Leistungsschalters ist, dass aufgrund interner Streueffekte der Kurzschlussstrom innerhalb eines einzelenen Nanodrahts begrenzt wird, bei einer Kohlenstoff-Nanoröhre beispielsweise auf etwa 24 µA. Der erfindungsgemäße Halbleiter-Leistungsschalter kann demnach auch als Anlaufstrombegrenzer eingesetzt werden.

Zum besseren Verständnis der Erfindung sei im Folgenden kurz auf die physikalischen Eigenschaften von Nanodrähten eingegangen. Nanodrähte sind eindimensionale Strukturen, die metallische Eigenschaften bzw. Halbleitereigenschaften aufweisen können. "Eindimensional" bedeutet in diesem Zusammenhang, dass sich aufgrund der kleinen Abmessungen der Nanodrähte (Nanometerbereich) die einzelnen Energieniveaus der Elektronen weiter als die thermische Energie (-25 meV) auseinanderliegen, so dass sich Elektronen nur in einem Leitungskanal aufhalten. Nanodrähte können beispielsweise Röhren (innen "hohl", dünne Drähte (mit Material "gefüllt"), dünne Flächen oder auch einzelne Atomketten sein.

In dieser Erfindung werden die elektronischen Eigenschaften der Nanodrähte, beispielsweise Kohlenstoff-Nanoröhren oder andere eindimensionale Strukturen, benützt, um Bauelemente der Leistungselektronik (Schalten von mehreren Ampère) zu erzeugen, die durch ihren nanostrukturierten Aufbau eine wesentlich bessere Performanz erzielen als konventionelle Leistungs-Bauelemente. Erfindungsgemäß können also wesentlich höhere Ströme/Spannungen als bei herkömmlichen Nanoelektronikbauelementen (0,1 - 5 V, 25 µA) verarbeitet werden, beispielsweise Spannungen bis mehr als 500 V und Ströme von mehr als 2000 A/cm². Ausschlaggebend ist dabei die Kombination aus einer Parallelschaltung mehrerer Nanodrähte und der hohen Ladungsträgermobilität in diesen eindimensionalen Gebilden, verbunden mit einer Skalierungsvorschrift für die Länge dieser Nanodrähte.

Die im erfindungsgemäßen Halbleiter-Leistungsschalter eingesetzten Nanodrähte können prinzipiell eine beliebige Struktur aufweisen und bestehen aus Material mit HalbleiterEigenschaften, beispielsweise Silizium oder Kohlenstoff, wobei erfindungsgemäß insbesondere Kohlenstoff-Nanoröhren Verwendung finden. Der geringe Einschaltwiderstand, der sich mit Nanodrähten erzielen lässt, beruht darauf, dass Elektronen, die durch einen Nanodraht geleitet werden, statistisch mit einer sehr viel geringeren Wahrscheinlichkeit gestreut werden als Elektronen, die durch einen ausgedehnten Halbleiterkristall hindurchfließen. So zeigen z. B. Kohlenstoff-Nanoröhren die höchste je bei Raumtemperatur gemessene Mobilität von über 100000 cm²/Vs.

Die Länge der Nanodrähte beträgt vorzugsweise ((0,2 µm) * (Maximalwert der an dem Halbleiter-Leistungsschalter anliegenden Spannung in Volt)). Die Erfindung ist jedoch nicht auf diese Faustregel beschränkt.

Die Parallelschaltung der Nanodrähte lässt sich auf mehrerlei Arten realisieren. Vorzugsweise sind die Nanodrähte als "Stäbchen" ausgebildet, die parallel zueinander verlaufen, wobei ein Ende eines jeden Stäbchens den Sourcekontakt, und das andere Ende den Drainkontakt kontaktiert. Die Nanodrähte müssen jedoch nicht zwingend eine stäbchenförmige Ausgestaltung aufweisen, auch krummlinige Formen sind prinzipiell möglich. Wichtig ist, dass jeder Nanodraht eine eigenständige elektrische Verbindung zwischen Sourcekontakt und Drainkontakt herstellt, so dass eine Parallelschaltung elektrischer Verbindungen zwischen Source- und Drainkontakt besteht.

Bei der Erfindung ist das Gate in Form mehrerer Gatebänder realisiert, deren Längsausrichtung jeweils senkrecht zur Ausrichtung der Nanodrähte verläuft, und deren Querausrichtung der Ausrichtung der Nanodrähte entspricht, wobei die Nanodrähte gegenüber dem Gate, d. h. den Gatebändern, elektrisch isoliert sind. In dieser Ausführungsform wird das Gate also nicht durch die Nanodrähte durchstoßen, vielmehr verlaufen die Nanodrähte parallel zu Oberflächen der Gatebänder. Dabei verlaufen die Nanodrähte innerhalb von Nanodraht-Gräben, die zwischen den Gatebändern vorgesehen sind, d. h. Nanodraht-Gräben und Gatebänder wechseln miteinander ab.

Prinzipiell können die Gatebänder und/oder Gräben beliebig voneinander beabstandet sein, vorzugsweise sind die Gatebänder und/oder die Nanodraht-Gräben jedoch äquidistant voneinander beabstandet.

Innerhalb der Nanodraht-Gräben können Röhren vorgesehen werden, innerhalb derer jeweils wenigstens ein Nanodraht verläuft; vorzugsweise verlaufen innerhalb einer Röhre mehrere Nanodrähte. Die Röhren dienen hierbei als Führung während des Aufwachsprozesses der Nanodrähte.

Zur Isolation der Nanodrähte gegenüber den Gatebändern können beispielsweise zwischen den Nanodraht-Gräben und den Gatebändern Isolationsschichten vorgesehen werden.

Da das Gate in Form mehrerer Gatebänder realisiert ist, können die Nanodrähte innerhalb der Nanodraht-Gräben bzw. innerhalb der Röhren einander auch kontaktieren bzw. eine inhomogene Beabstandung zueinander aufweisen.

Die Gatebänder weisen vorzugsweise eine Schichtdicke/Bandweite auf, die ungefähr ein Drittel des Abstands zwischen dem Sourcekontakt und dem Drainkontakt beträgt. Die Erfindung ist jedoch nicht auf derartige Dicken/Breiten beschränkt, beliebige andere Werte sind ebenfalls möglich.

Die Gatebänder können jeweils aus einer zusammenhängenden Schicht bestehen oder jeweils in mehrere voneinander isolierte Gate-Unterbänder aufgespalten sein. Im letzteren Fall verläuft die Längsausrichtung jedes Gate-Unterbands senkrecht zur Ausrichtung der Nanodrähte, wobei die Querausrichtung der Gate-Unterbänder der Ausrichtung der Nanodrähte entspricht. Jedes Gateband ist also in mehrere kleine, parallel zueinander verlaufende Unterbänder aufgeteilt, die die gleiche Ausrichtung wie das Gateband aufweisen.

Die Gate-Unterbänder sind vorzugsweise einzeln ansteuerbar ausgestaltet, d. h. jedes der Gate-Unterbänder kann auf ein individuelles Potenzial gesetzt werden. Vorteilhafterweise sind die Gate-Unterbänder eines Gatebandes äquidistant voneinander beabstandet. Die vertikalen Positionen der Gate-Unterbänder eines bestimmten Gatebands können gegenüber den vertikalen Positionen der Gate-Unterbänder benachbarter Gatebänder verschoben beziehungsweise gleichgerichtet sein.

Bei einer Aufspaltung der Gatebänder in Gate-Unterbänder kann die Sperrwirkung des erfindungsgemäßen Halbleiter-Leistungsschalters wie folgt verbessert werden: Im Sperrzustand werden die Potenziale der Gate-Unterbänder so gewählt, dass die Band-Gap-Strukturen der Nanodrähte eine wellenförmige Gestalt annehmen. Dies kann beispielsweise dadurch erreicht werden, dass die Potenziale übereinander liegender Gate-Unterbänder alternierende Werte aufweisen, d.h. zwei unmittelbar übereinander angeordnete Gate-Unterbänder weisen unterschiedliche Potenziale auf, das Potenzial jedes zweiten Gate-Unterbands hat hingegen denselben Wert. Die benachbarten Gate-Unterbänder auf einer Ebene (gleiche vertikale Position) sollten im Sperrzustand in diesem Beispiel dasselbe Potenzial aufweisen. Die alternierende Potenzialstruktur bewirkt, dass das Band-Gap (Bandabstand) der zwischen den benachbarten Gate-Unterbänder liegenden Nanodrähte in eine wellenförmige Struktur gebogen wird. Die wellenförmige Struktur bewirkt hierbei ein Einfangen von Elektronen bzw. Löchern, die sich zwischen dem Source- und Drainkontakt bewegen, womit der Stromfluss zwischen Source- und Drainkontakt behindert wird, was wiederum die Sperrfähigkeit des Halbleiter-Leistungsschalters verbessert. Im Durchlasszustand des Halbleiter-Leistungsschalters werden die Gate-Unterbänder eines Gatebands hingegen auf gleiches Potenzial gesetzt, d.h. in diesem Fall werden alle Gate-Unterbänder auf dasselbe Potenzial gesetzt. Damit wird die wellenförmige Bandstruktur aufgehoben und eine Verbesserung der Durchlasseigenschaften der Halbleiterstruktur (Nanodrähte) für Löcher und Elektronen erzielt.

Die Nanodrähte sind in einer bevorzugten Ausführungsform halbleitende Kohlenstoff-Nanoröhren. Die Nanodrähte können
- Silizium;
- Germanium;
- zumindest einen der III-V-Halbleiter BN, BP, BAs, AlN, AlP, AlAs, AlSb, GaN, GaP, GaAs, GaSb, InN, InP, InAs, InSb;
- zumindest einen der II-VI-Halbleiter ZnO, ZnS, ZnSe, ZnTe, CdS, CdSe, CdTe, HgS, HgSe, HgTe, BeS, BeSe, BeTe, MgS, MgSe;
- zumindest eine der Verbindungen GeS, GeSe, GeTe, SnS, SnSe, SnTe, PbO, PbS, PbSe, PbTe,
- zumindest eine der Verbindungen CuF, CuCl, CuBr, CuI, AgF, AgCl, AgBr, AgI;
enthalten oder eine Kombination aus diesen Materialien enthalten. Die Nanodrähte können p-dotiert oder n-dotiert sein.

Ferner ist ein die obige Aufgabe lösendes Verfahren zur Herstellung eines Halbleiter-Leistungsschalters, mit den folgenden Schritten: Ausbilden einer Schichtstruktur auf einem Drainkontakt, die eine erste Isolationsschicht, eine darüber angeordnete Gateschicht und eine über der Gateschicht angeordnete zweite Isolationsschicht aufweist, Ausbilden von Gräben in der Schichtstruktur, die bis zum Drainkontakt reichen, Ausbilden von Nanodrähten innerhalb der Gräben, Ausbilden eines Source-Kontakts auf der Oberseite der Schichtstruktur, die folgenden Schritte: Ausbilden von ersten Gräben in der Schichtstruktur, Auffüllen der ersten Gräben mit Gateoxid, Ausbilden von zweiten Gräben im Gateoxid, wobei die zweiten Gräben bis zum Drainkontakt reichen, Ausbilden von Nanodrähten innerhalb der zweiten Gräben, Ausbilden eines Source-Kontakts auf der Oberseite der Schichtstruktur.

Der Drainkontakt ist vorzugsweise ein Molybdän- oder Tantalblech, kann aber auch ein Siliziumsubstrat sein, das mit einer Metallschicht versehen ist. Zur Verbesserung des Aufwachsverhaltens der Nanodrähte kann vor deren Ausbildung auf dem Molybdän- oder Tantalblech oder dem Siliziumsubstrat vor Ausbilden der Schichtstruktur bzw. unmittelbar vor Ausbilden der Nanodrähte (d.h. nach Ausbilden der Gräben) ein Katalysator abgeschieden werden. Zur Stabilisierung des Herstellungsverfahrens kann der Drainkontakt zunächst auf einem Opfersubstrat ausgebildet werden, das nach Fertigstellung des Halbleiter-Leistungsschalters dann aufgelöst wird.

Die Erfindung wird im Folgenden unter Bezugnahme auf die Figuren in beispielsweiser Ausführungsform näher erläutert. Es zeigen:
- Fig. 1: ein nicht zur Erfindung zählendes Vergleichsbeispiel eines Halbleiter-Leistungsschalters in Querschnittsdarstellung.
- Fig. 2: eine erste bevorzugte Ausführungsform eines erfindungsgemäßen Halbleiter-Leistungsschalters in Querschnittsdarstellung.
- Fig. 3a bis 3b: einen ersten bis vierten Prozessschritt eines Herstellungsverfahrens zur Herstellung des in Fig. 2 gezeigten Halbleiter-Leistungsschalters.
- Fig. 4: eine erste Ausführungsvariante des in Fig. 2 gezeigten Halbleiter-Leistungsschalters in einer Draufsicht.
- Fig. 5: eine zweite Ausführungsvariante des in Fig. 2 gezeigten Halbleiter-Leistungsschalters in einer Draufsicht.
- Fig. 6: eine zweite bevorzugte Ausführungsform des erfindungsgemäßen Halbleiter-Leistungsschalters in Querschnittsdarstellung.
- Fig. 7: eine Bandstruktur, die in einem Sperrzustand in dem in Fig. 6 gezeigten Halbleiter-Leistungsschalter auftritt.
- Fig. 8: eine Bandstruktur, die im Durchlasszustand in dem in Fig. 6 gezeigten Halbleiter-Leistungsschalter auftritt.
- Fig. 9: ein Diagramm, das die Abhängigkeit des Einschaltwiderstands von der Nanodrahtdichte bei dem in Fig. 1 gezeigten Vergleichsbeispiels verdeutlicht.
- Fig. 10: ein Diagramm, das die Abhängigkeit der maximal möglichen Stromdichte von der Nanodrahtdichte bei dem in Fig. 1 gezeigten Vergleichsbeispiels illustriert.
- Fig. 11: ein Diagramm, das den Zusammenhang einer maximal möglichen Nanodrahtdichte bei einer vorgegebenen Spannungsdifferenz zwischen Nanodrähten und dem Gate für das in Fig. 1 gezeigte Vergleichsbeispiel eines Halbleiter-Leistungsschalter illustriert.
- Fig. 12: ein Diagramm, das eine maximal mögliche Stromdichte durch den Halbleiter-Leistungsschalter in Abhängigkeit der Nanodrahtdichte illustriert.

In den Figuren sind identische bzw. einander entsprechende Teile mit denselben Bezugsziffern gekennzeichnet.

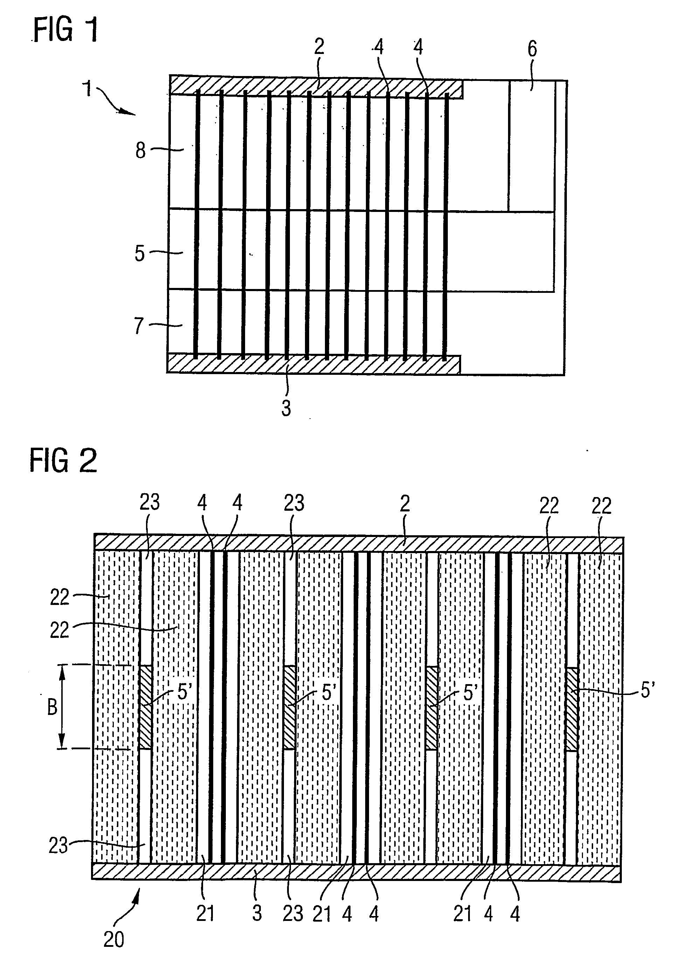

Das in Fig. 1 gezeigte Vergleichsbeispiel 1 eines erfindungsgemäßen Halbleiter-Leistungsschalters weist einen Sourcekontakt 2, einen Drainkontakt 3, eine Mehrzahl von Nanodrähten 4, ein Gate 5, einen Gateanschluss 6, eine erste Isolationsschicht 7, und eine zweite Isolationsschicht 8 auf.

Die Nanodrähte 4 sind parallel und im Wesentlichen äquidistant zueinander angeordnet, wobei die oberen Enden der Nanodrähte 4 mit dem Sourcekontakt 2, und die unteren Enden der Nanodrähte 4 mit dem Drainkontakt 3 elektrisch in Verbindung stehen. Das Gate 5 ist in Form einer Gateschicht ausgestaltet, die von den Nanodrähten 4 durchstoßen werden, wobei die Nanodrähte 4 gegenüber dem Gate 5 (der Gateschicht) elektrisch isoliert sind. Damit ist eine koaxiale Anordnung der Gateelektrode gegenüber den Nanodrähten gegeben, so dass man die bestmögliche kapazitive Kopplung der Gate-Elektrode an den Nanodraht erhält. Die Länge der Nanodrähte beträgt vorzugsweise ((0,2 µm) * (Maximalwert der an dem Halbleiter-Leistungsschalter anliegenden Spannung (in Volt))). Die Dicke der Gateschicht 5 beträgt vorzugsweise ein Drittel des Abstandes zwischen dem Sourcekontakt 2 und dem Drainkontakt 3. Die Gateschicht 5 sollte sich näher an demjenigen Kontakt befinden, dessen Potenzial dem Erdungspotenzial am nächsten liegt (hier: dem Drainkontakt). Die Gateschicht 5 kann beispielsweise eine quadratische, kreisförmige oder auch ringförmige Form aufweisen.

Wie bereits erwähnt, empfiehlt sich je nach zu erzielender Spannungsfestigkeit des Halbleiter-Leistungsschalters eine Länge der Nanodrähte von 0,2 µm pro angelegtem Volt Spannung, d. h. bei 100 Volt Betriebsspannung beispielsweise eine Länge von 15 bis 25 µm. Nanodrähte dieser Länge weisen eine sehr hohe Mobilität von ca. 100.000 cm²/Vs auf.

Der in Fig. 1 gezeigte Aufbau lässt sich insbesondere auf quadratmillimeter- bzw. quadratzentimetergroße Halbleiter-Leistungsschalter anwenden. Jedoch ist eine Anwendung auf kleinere bzw. größere Halbleiter-Leistungsschalter ebenfalls denkbar.

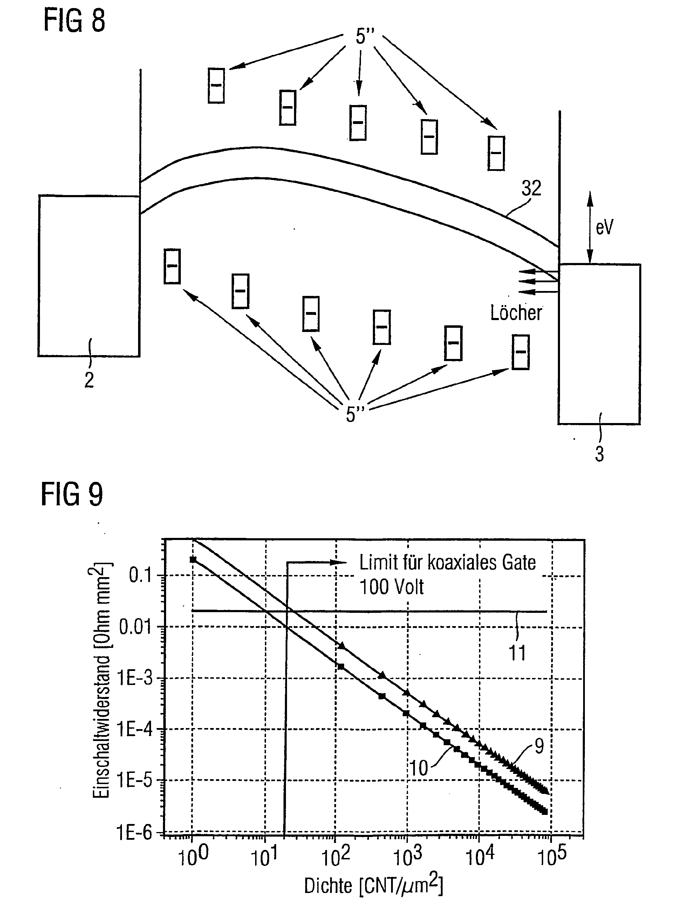

In Fig. 9 ist der erzielbare Einschaltwiderstand der in Fig. 1 gezeigten Anordnung in Abhängigkeit der Nanodrahtdichte aufgezeigt. Die mit Bezugsziffer 9 gekennzeichnete Kennlinie entspricht einem angenommenen Einschalt-Widerstandswert von 500 kΩ pro Nanodraht, die mit Bezugsziffer 10 gekennzeichnete Kennlinie einem angenommenen Einschalt-Widerstandswert von 200 kΩ pro Nanodraht. Die mit Bezugsziffer 11 gekennzeichnete Kennlinie entspricht der derzeit bestmöglichen Kennlinie eines herkömmlichen Halbleiter-Leistungsschalters, der beispielsweise auf Silizium-Technologie basiert. Aus Fig. 9 ist ersichtlich, dass die Eigenschaften des in Fig. 1 gezeigten Halbleiter-Leistungsschalters wesentlich besser sind als die eines herkömmlichen Halbleiter-Leistungsschalters.

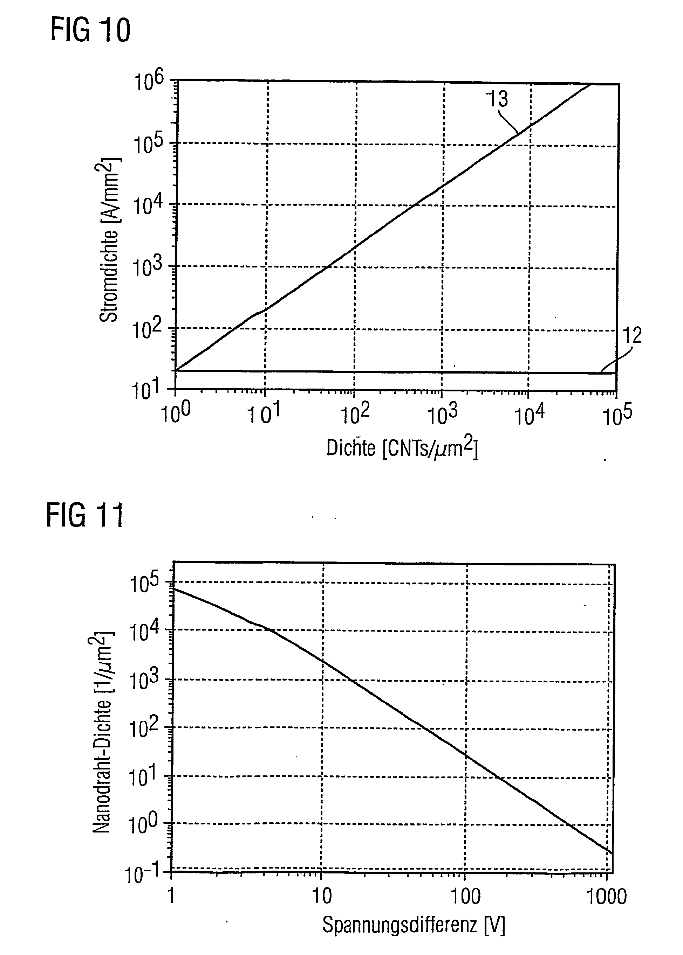

In diesem Zusammenhang sei noch auf Fig. 10 eingegangen, die die Stromtragfähigkeit der in Fig. 1 gezeigten Anordnung in Abhängigkeit der Nanodrahtdichte zeigt. Bezugsziffer 12 bezeichnet hierbei die derzeit bestmögliche Kennlinie eines herkömmlichen Halbleiter-Leistungsschalters, Bezugsziffer 13 die Kennlinie des in Fig. 1 gezeigten Vergleichsbeispiel eines Halbleiter-Leistungsschalters. Es ist deutlich zu sehen, dass Letzterer die besseren Werte aufweist.

Das in Fig. 1 gezeigte Vergleichsbeispiel einer Halbleiter-Leistungsschaltung kann beispielsweise wie folgt hergestellt werden: Zunächst wird auf einem NaCl-, SiO₂-, Si- oder einem sonstigen Substrat ein Kontaktmaterial, beispielsweise Molybdän, aufgebracht. Auf dem Substrat wird ein geeigneter Katalysator abgeschieden. Beispielsweise eignet sich Eisen, Nickel, Kobalt oder Verbindungen dieser Elemente fur das Aufwachsen von Si-Nanodrähten oder Nanodrähten aus II-V oder IV Halbleitern. Für den speziellen Fall von Kohlenstoffnanoröhren sollte der Katalysator ein silizidbildendes Material sein wie z. B. Gold, Silber oder Platin. Sodann wird die erste Isolationsschicht 7 (beispielsweise Oxid), auf der wiederum die Gateschicht 5 abgeschieden wird, aufgebracht. Die Gateschicht 5 wird strukturiert und mit Dielektrikum versehen, d.h. die Gateschicht mit Löchern, die bis zur Isolationsschicht 7 reichen, versehen und diese Löcher dann erneut durch eine Isolationsschicht aufgefüllt. Auf der Gateschicht 5 wird die zweite Isolationsschicht 8 aufgebracht. Sodann werden Löcher in die Schichtstruktur aus erster Isolationsschicht 7, Gateschicht 5, und zweiter Isolationsschicht 8 geätzt und in den Löchern Nanoröhren bzw. Nanodrähte gewachsen.

Alternativ hierzu können ein Schichtstapel, bestehend aus erster Isolationsschicht 7, Gate 5, und zweiter Isolationsschicht 8 abgeschieden, und mit einem Trockenätzprozess Löcher bis zum Boden geätzt werden. Die Löcher werden nochmals durch Abscheidung einer Isolationsschicht mit einem Atomic-Layer-Deposition- (ALD) oder einem CVD-Verfahren verjüngt, wobei gleichzeitig das Gateoxid über dem Gate realisiert wird. Ein Spacer-Ätzprozess legt dann erneut den Boden/Katalysator frei, und die Nanodrähte 4 werden in den erzeugten Löchern gewachsen.

Eventuelle Hohlstellen können beispielsweise mit einem Spinon-Glas versiegelt werden. Elektrodenposition ist möglich. Auf die Oberseite der Schichtstruktur wird der Sourcekontakt 2 aufgebracht. Das Substrat (Opfersubstrat) wird aufgelöst, womit das Kontaktmaterial (Drainkontakt 3) freigelegt wird.

In Fig. 2 ist eine erste Ausführungsform 20 des erfindungsgemäßen Halbleiter-Leistungsschalters gezeigt. Ein wesentlicher Unterschied zu dem in Fig. 1 gezeigten Vergleichsbeispiel ist, dass das Gate in Form mehrerer Gatebänder 5' realisiert ist, deren Längsausrichtung jeweils senkrecht zur Ausrichtung der Nanodrähte 4 verläuft, also aus der Zeichenebene heraus bzw. in die Zeichenebene hinein zeigt, und deren Querausrichtung der Ausrichtung der Nanodrähte 4 entspricht. Die Nanodrähte 4 sind innerhalb von Gräben 21 angeordnet. Jedes Gateband 5' wird durch Isolierschichten (Gateoxidschichten) 22 gegenüber den Nanodrähten 4 elektrisch isoliert. Oberhalb und unterhalb der Gatebänder 5' sind weitere Isolierschichten (Oxidschichten) 23 vorgesehen.

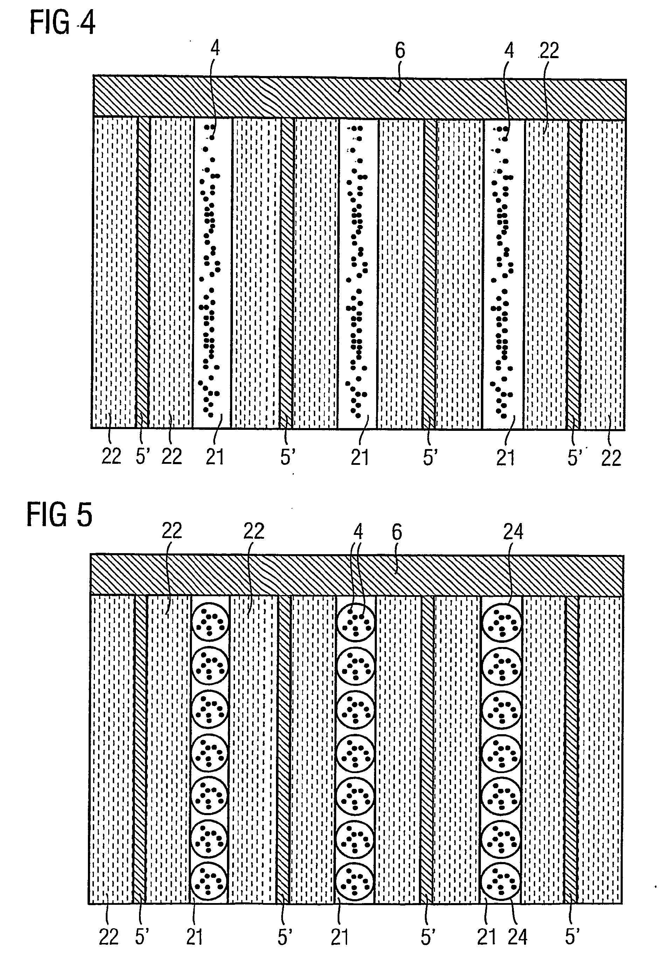

In Fig. 4 und 5 sind Draufsichten zwei möglicher Ausführungsformen des in Fig. 2 gezeigten Halbleiter-Leistungsschalters veranschaulicht. In Fig. 4 sind die Nanodrähte 4 inhomogen innerhalb der Gräben 21 verteilt, in Fig. 5 sind innerhalb der Gräben 21 mehrere Röhren 24 vorgesehen, wobei innerhalb jeder Röhre 24 wenigstens ein Nanodraht 4 verläuft. Auch bei der in Fig. 2 gezeigten Ausführungsform beträgt eine Breite B der Gatebänder 5' vorzugsweise ein Drittel des Abstands zwischen dem Sourcekontakt 2 und dem Drainkontakt 3.

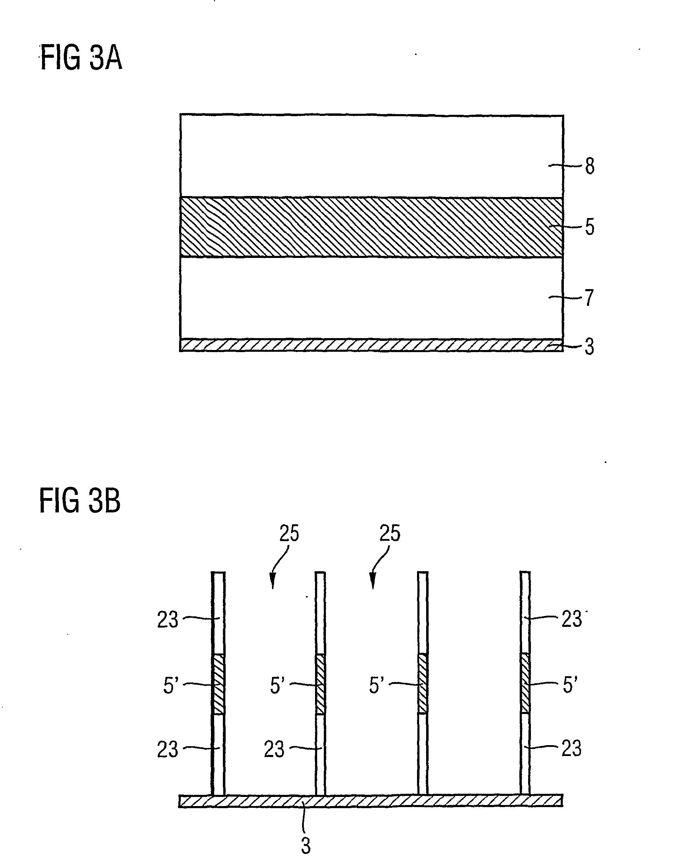

Im Folgenden soll unter Bezugnahme auf die Figuren 3a bis 3d eine bevorzugte Ausführungsform des erfindungsgemäßen Herstellungsverfahrens des in Fig. 2 gezeigten Halbleiter-Leistungsschalters näher erläutert werden.

In einem ersten Schritt (Fig. 3a) wird auf einem Drainkontakt 3 eine erste Isolationsschicht 7, darauf eine Gateschicht 5, und darauf wiederum eine zweite Isolierschicht 8 aufgebracht. In einem zweiten Schritt (Fig. 3b) werden in der so entstandenen Schichtstruktur erste Gräben 25 ausgebildet, beispielsweise durch einen Ätzprozess. Durch das Ausbilden der ersten Gräben 25 entstehen Gatebänder 5' sowie darauf bzw. darunter angeordnete Isolierschichten 23. Die ersten Gräben 25 reichen vorzugsweise bis zum Drainkontakt 3 hinab.

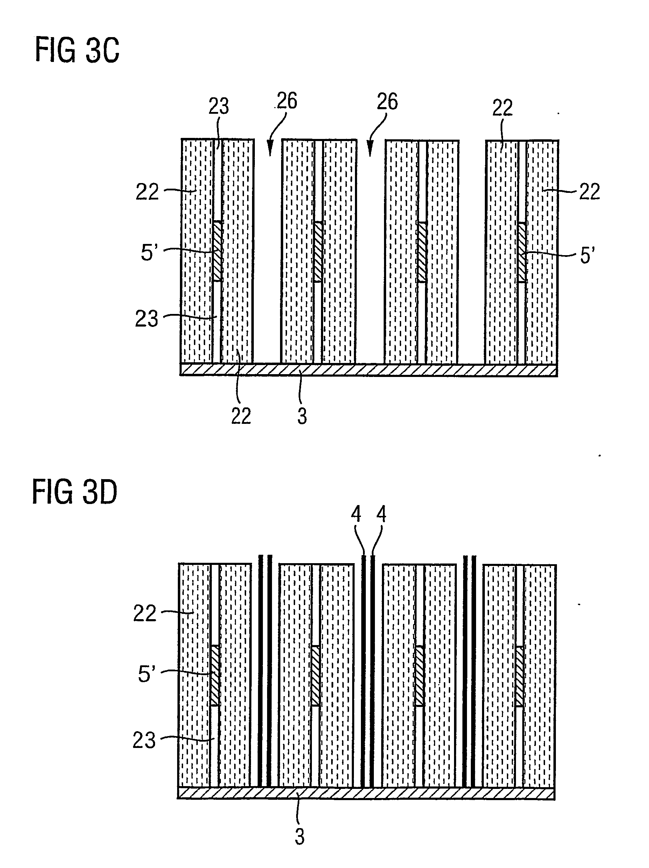

In einem dritten Schritt (Fig. 3c) werden die ersten Gräben 25 mit einem Isolationsmaterial aufgefüllt, und anschließend in dem Isolationsmaterial zweite Gräben 26 ausgebildet. Die zweiten Gräben 26 reichen bis zum Drainkontakt 3 hinab. Die Gatebänder 5' bzw. die darüber/darunter liegenden Isolationsschichten 23 sind nach diesem Prozessschritt von Isolierschichten 22 umgeben.

In einem vierten Prozessschritt (Fig. 3d) werden in den zweiten Gräben 26 Nanodrähte 4 aufgewachsen. Anschließend erfolgt die Ausbildung eines Sourcekontakts 2.

Die in Fig. 2 gezeigte erste Ausführungsform der Erfindung hat gegenüber dem in Fig. 1 gezeigten Vergleichsbeispiel den Vorteil, dass die "Durchschlagsfestigkeit" des Halbleiter-Leistungsschalters bei gleichzeitiger Wahrung einer hohen Nanodraht-Dichte höher ist:

Der in Fig. 1 gezeigte Halbleiter-Leistungsschalter des Vergleichsbeispiels hat den Nachteil, dass bei Anliegen von hohen Spannungen auch entsprechend dicke Isolierschichten, die die Nanodrähte gegenüber dem Gate 5 isolieren, verwendet werden müssen, um einen Durchschlag durch die Isolierschicht zu verhindern. Bei einer anzulegenden Spannung von 100 V sollte beispielsweise die Dicke der Isolierschicht mindestens 100 nm betragen. Dies würde jedoch bedeuten, dass bei einer koaxialen Realisierung in Fig. 1 unter Verwendung einer hexagonal dichtesten Packung von Nanodrähten maximal eine Dichte von 20 Nanodrähten pro µm² möglich wären, was herkömmliche Siliziumschalter nur um einen Faktor 2 hinsichtlich der Einschaltwiderstände und um einen Faktor 10 hinsichtlich der Strombelastbarkeit verbessern würde. Die in Fig. 2 gezeigte Ausführungsform der Erfindung verwendet deshalb parallele Gatebänder 5' für den Halbleiter-Leistungsschalter mit vertikal ausgerichteten Nanodrähten 4. Mit dieser Ausführungsform können trotz Spannungen von ca. 500 V Dichten von ungefähr 2000 Nanodrähten (beispielsweise Carbon-Nanodrähte oder Silizium-Nanodrähte) pro µm² erzielt werden.

Die Dicke des Drainkontakts beträgt ungefähr 10 bis 200 µm, wobei der Drainkontakt 3 vorzugsweise aus Molybdän oder Tantal besteht bzw. diese Materialien enthält. Auf dem Drainkontakt 3 ist zudem vorzugsweise eine Katalysatorschicht aufgebracht.

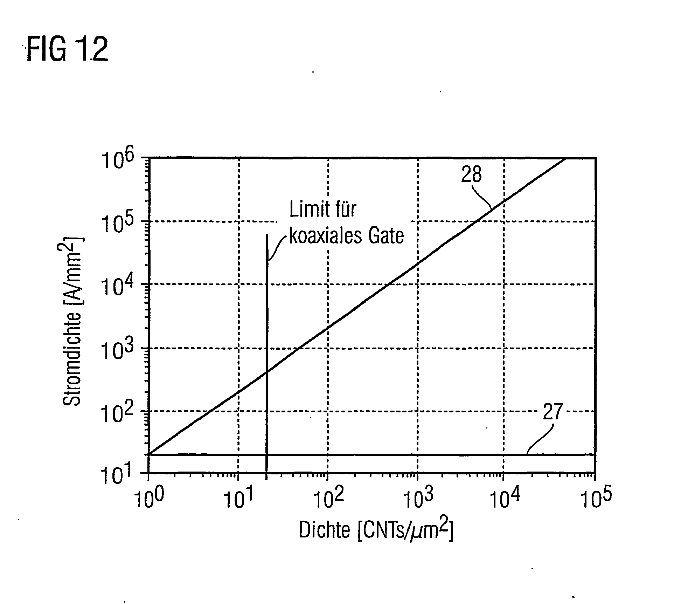

In diesem Zusammenhang sei noch auf die Fig. 11 und 12 verwiesen. Fig. 11 zeigt die maximal mögliche Nanodrahtdichte in Abhängigkeit angenommener Spannungsdifferenzen zwischen Nanodrähten und Gate für den in Fig. 1 gezeigten Halbleiter-Leistungsschalter mit koaxialem Gate für jeweils einen einzigen Nanodraht. Es ist zu sehen, dass bei hohen Spannungsdifferenzen nur geringe Nanodrahtdichten möglich sind. In Fig. 12 ist die Stromdichte gegenüber der Nanodrahtdichte für einen herkömmlichen Halbleiter-Leistungsschalter (Kennlinie 27) und für das in Fig. 2 gezeigte erfindungsgemäße Halbleiter-Leistungsbauteil (Kennlinie 28) gezeigt ("CNT" entspricht "Carbon-Nanotube" bzw. "Carbon-Nanoröhre"). Die Kennlinie 27 gilt insbesondere für Silizium-Leistungsschalter.

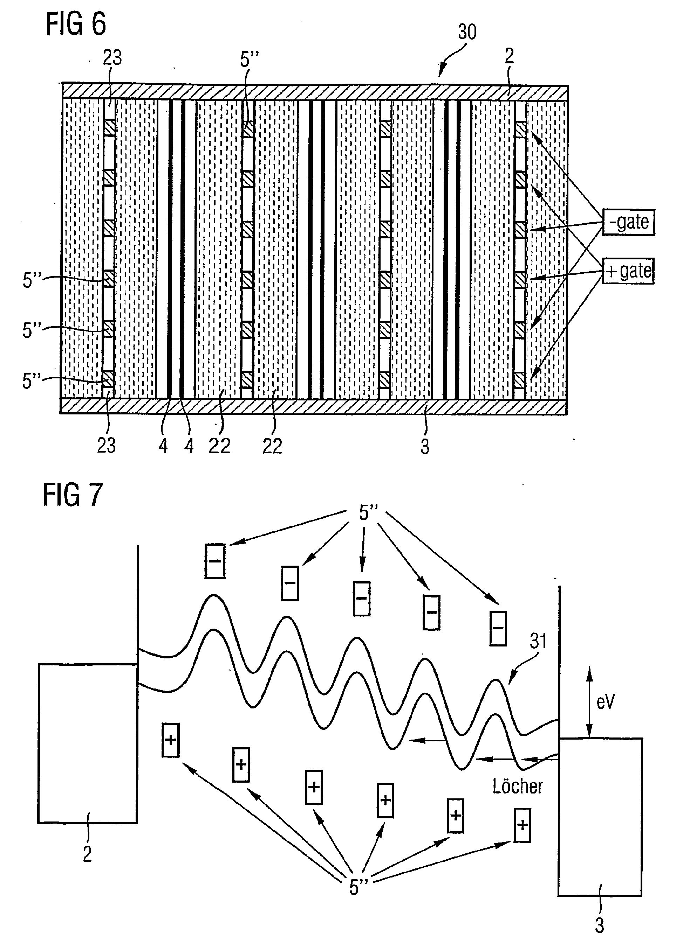

In Fig. 6 ist eine zweite Ausführungsform 30 des erfindungsgemäßen Halbleiter-Leistungsschalters gezeigt. Diese Ausführungsform unterscheidet sich von der in Fig. 2 gezeigten Ausführungsform dadurch, dass die in Fig. 2 gezeigten Gatebänder 5' jeweils in mehrere Gate-Unterbänder 5" aufgespalten sind. Die Gate-Unterbänder 5" sind gegeneinander elektrisch isoliert und in dieser Ausführungsform äquidistant voneinander beabstandet. Jedes der Gate-Unterbänder 5" kann unabhängig von den anderen Gate-Unterbändern 5" auf einen individuellen Potenzialwert gelegt werden. Wenn die Gate-Unterbänder 5" eines Gatebands 5' alternierend auf eine positive/negative Gatespannung gelegt werden, so lässt sich eine wellenförmige Bandabstandsstruktur ("band gap") erzeugen, so wie in Fig. 7 schematisch dargestellt. Die wellenförmige Bandabstandsstruktur 31 bewirkt, dass Löcher, die von dem Drainkontakt 3 zu dem Sourcekontakt 2 wandern wollen "eingefangen" werden. Äquivalentes gilt auch für die Elektronen, die in Fig. 7 nicht explizit eingezeichnet sind, in Fig. 7 aber von der mit Bezugsziffer 2 gekennzeichneten Elektrode zu der mit Bezugsziffer 3 gekennzeichneten Elektrode tunneln. Damit lassen sich die Sperreigenschaften des Halbleiter-Leistungsschalters wesentlich verbessern: Im Sperrzustand werden, wie oben beschrieben, die Gate-Unterbänder 5" mit Spannung versorgt, so dass die in Fig. 7 gezeigte wellenförmige Bandabstandsstruktur entsteht. Im Durchlasszustand des Halbleiter-Leistungsschalters werden hingegen sämtliche Gate-Unterbänder 5" eines Gatebands 5' mit derselben Gatespannung beaufschlagt, so dass die in Fig. 8 gezeigte Bandabstandsstruktur 32 entsteht. Löcher können nun ungehindert von dem Drainkontakt 3 zu dem Sourcekontakt 2 wandern.

Die in Fig. 6 gezeigte zweite Ausführungsform 30 ermöglicht demnach, unter normalen Umständen auftretende Tunneleffekte von Elektronen/Löchern durch die an dem Sourcekontakt 2 und dem Drainkontakt 3 vorhandene Schottky-Barriere durch Ausbilden der wellenförmigen Band-Gap-Struktur 31 im Sperrzustand zu unterdrücken. Dazu werden die Gate-Unterbänder 5" abwechselnd "gebiased", wodurch ein hohes Abschnürverhalten der Ladungsträger resultiert, wobei die Abschnürstärke exponentiell mit der Anzahl n der ±-modulierten Gebiete ansteigt. Damit kann bei gleichem Durchlassstrom im Durchlasszustand der Tunnelstrom (Leckstrom) im Sperrzustand um einen Faktor eⁿ reduziert werden. "eV" bezeichnet hierbei die angelegte Spannung. Da es sich um ein Energiediagramm handelt ist diese Spannung mit "e" multipliziert.

Erfindungsgemäß werden demnach Gatestrukturen mit abwechselnd leitenden und nicht-leitenden Schichten vorgesehen, die mit abwechselnder Polarität als multiple Gateanordnung verschaltet werden.

### Literatur:

Volume 88, No. 25, PHYSICAL REVIEW LETTERS, 24. Juni 2002 "Multiple Funcitonality in Nanotube Transistors" François Léonard and J. Tersoff
Volume 85, No. 22, PHYSICAL REVIEW LETTERS, 27. November 2000 "Negative Differential Resistance in Nanotube Devices" François Léonard and J. Tersoff

### Bezugszeichenliste

- 1: Vergleichsbeispiel
- 2: Sourcekontakt
- 3: Drainkontakt
- 4: Nanodraht
- 5: Gate
- 5': Gateband
- 5": Gate-Unterband
- 6: Gateanschluss
- 7: erste Isolationsschicht
- 8: zweite Isolationsschicht
- 9: Kennlinie
- 10: Kennlinie
- 11: Kennlinie
- 12: Kennlinie
- 13: Kennlinie
- 20: erste Ausführungsform
- 21: Graben
- 22: Isolierschicht
- 23: Isolierschicht
- 24: Röhre
- B: Breite des Gatebands
- 25: erste Gräben
- 26: zweite Gräben
- 27: Kennlinie
- 28: Kennlinie
- 30: zweite Ausführungsform
- 31: Bandabstandsstruktur
- 32: Bandabstandsstruktur

## Patentansprüche

1. Halbleiter-Leistungsschalter (1, 20, 30), mit:
- einem Sourcekontakt (2),
- einem Drainkontakt (3),
- einer zwischen Sourcekontakt (2) und Drainkontakt (3) vorgesehenen Halbleiterstruktur, und
- einem Gate (5), über das ein Stromfluss zwischen Sourcekontakt (2) und Drainkontakt (3) durch die Halbleiterstruktur hindurch steuerbar ist,
- wobei die Halbleiterstruktur mehrere parallel geschaltete Nanodrähte (4) aufweist, die so angeordnet sind, dass jeder Nanodraht (4) eine elektrische Verbindung zwischen dem Sourcekontakt (2) und dem Drainkontakt (3) ausbildet,
**dadurch gekennzeichnet,**
**dass** das Gate (5) in Form mehrerer Gatebänder (5') realisiert ist, die jeweils durch eine Länge, eine Breite und eine Dicke definiert sind, die Nanodrähte (4) innerhalb von Gräben (21) verlaufen, die zwischen den Gatebändern (5') vorgesehen sind, wobei die Längsachsen der Gatebänder (5'), parallel zu den Gräben, im Wesentlichen senkrecht zu den Längsachsen der Nanodrähte (4) verlaufen, wobei in einem Graben (21) mehrere Nanodrähte (4) verlaufen, und die Breite der Gatebänder (5'), die parallel zu den Nanodrähten (4) definiert ist, größer ist als die Dicke.

2. Halbleiter-Leistungsschalter (1, 20, 30) nach Anspruch 1,
**dadurch gekennzeichnet,**
**dass** die Gatebänder (5') und/oder Gräben (1) äquidistant voneinander beabstandet sind.

3. Halbleiter-Leistungsschalter (1, 20, 30) nach Anspruch 1 oder 2,
**dadurch gekennzeichnet,**
**dass** innerhalb der Gräben (21) Röhren (24) vorgesehen sind, innerhalb derer jeweils wenigstens ein Nanodraht (4) verläuft.

4. Halbleiter-Leistungsschalter (1, 20, 30) nach einem der Ansprüche 1 bis 3,
**dadurch gekennzeichnet,**
**dass** zwischen den Gräben (21) und den Gatebändern (5') Isolationsschichten (22) vorgesehen sind.

5. Halbleiter-Leistungsschalter (1, 20, 30) nach einem der vorstehenden Ansprüche,
**dadurch gekennzeichnet,**
**dass** die Nanodrähte (4) gegeneinander isoliert sind.

6. Halbleiter-Leistungsschalter (1, 20, 30) nach einem der vorstehenden Ansprüche,
**dadurch gekennzeichnet,**
**dass** die Nanodrähte (4) gleichmäßig voneinander beabstandet sind.

7. Halbleiter-Leistungsschalter (1, 20, 30) nach einem der Ansprüche 1 bis 6,
**dadurch gekennzeichnet,**
**dass** die Gatebänder (5, 5') eine Bandbreite aufweisen, die ungefähr 1/3 des Abstands zwischen dem Sourcekontakt (2) und dem Drainkontakt (3) beträgt.

8. Halbleiter-Leistungsschalter (30) nach einem der Ansprüche 1 bis 7,
**dadurch gekennzeichnet,**
**dass** jedes Gateband (5') in mehrere gegeneinander isolierte Gate-Unterbänder (5") aufgespalten ist, wobei die Gate-Unterbänder (5") übereinander angeordnet und jeweils einzeln ansteuerbar ausgestaltet sind.

9. Halbleiter-Leistungsschalter (30) nach Anspruch 8,
**dadurch gekennzeichnet,**
**dass** die Gate-Unterbänder (5") eines Gatebands (5') äquidistant voneinander beabstandet sind.

10. Halbleiter-Leistungsschalter (30) nach Anspruch 9,
**dadurch gekennzeichnet,**
**dass** die vertikalen Positionen der Gate-Unterbänder (5") eines Gatebands (5') gegenüber den vertikalen Positionen der Gate-Unterbänder (5") eines benachbarten Gatebands (5') verschoben sind.

11. Halbleiter-Leistungsschalter (1, 20, 30) nach einem der vorstehenden Ansprüche,
**dadurch gekennzeichnet,**
**dass** die Nanodrähte (4) halbleitende Kohlenstoff-Nanoröhren sind.

12. Halbleiter-Leistungsschalter (1, 20, 30) nach einem der vorstehenden Ansprüche,
**dadurch gekennzeichnet,**
**dass** die Nanodrähte (4)
- Silizium;
- Germanium;
- zumindest einen der III-V-Halbleiter BN, BP, BAs, AlN, AlP, AlAs, AlSb, GaN, GaP, GaAs, GaSb, InN, InP, InAs, InSb;
- zumindest einen der II-VI-Halbleiter ZnO, ZnS, ZnSe, ZnTe, CdS, CdSe, CdTe, HgS, HgSe, HgTe, BeS, BeSe, BeTe, MgS, MgSe;
- zumindest eine der Verbindungen GeS, GeSe, GeTe, SnS, SnSe, SnTe, PbO, PbS, PbSe, PbTe,
- zumindest eine der Verbindungen CuF, CuCl, CuBr, CuI, AgF, AgCl, AgBr, AgI;
enthalten.

13. Halbleiter-Leistungsschalter (1, 20, 30) nach Anspruch 11 oder 12,
**dadurch gekennzeichnet,**
**dass** die Nanodrähte (4) p-dotiert oder n-dotiert sind.

14. Halbleiter-Leistungsschalter (1, 20, 30) nach einem der vorstehenden Ansprüche,
**dadurch gekennzeichnet,**
**dass** die Länge der Nanodrähte (4) ((0,2µm) * (Maximalwert der an dem Halbleiter-Leistungsschalter anliegenden Spannung (in V))) beträgt.

15. Halbleiter-Leistungsschalter gemäß einem der Ansprüche 8 bis 13, bei dem jedes Gateband (5') in mehrere voneinander isolierte Gate-Unterbänder (5") aufgespalten ist, wobei die Gate-Unterbänder (5") übereinander angeordnet und jeweils einzeln ansteuerbar ausgestaltet sind,
**dadurch gekennzeichnet,**
**dass** im Sperrzustand die Potenziale der Gate-Unterbänder (5") so wählbar sind, dass die Band-Gap-Strukturen der Nanodrähte eine wellenförmige Gestalt annehmen.

16. Verfahren zur Herstellung eines Halbleiter-Leistungsschalters, mit den folgenden Schritten:
- Ausbilden einer Schichtstruktur auf einem Drainkontakt (3), die eine erste Isolationsschicht (7), eine darüber angeordnete Gateschicht (5) und eine über der Gateschicht angeordnete zweite Isolationsschicht (8) aufweist,
- Ausbilden von Gräben (21) in der Schichtstruktur, die bis zum Drainkontakt (3) reichen,
- Ausbilden von Nanodrähten (4) innerhalb der Gräben (21),
- Ausbilden eines Source-Kontakts (2) auf der Oberseite der Schichtstruktur, wobei das Verfahren
**gekennzeichnet ist durch**
die folgenden Schritte:
- Ausbilden von ersten Gräben (25) in der Schichtstruktur, wodurch die Gateschicht (5) in Form mehrerer Gatebänder (5') realisiert wird, die jeweils **durch** eine Länger, parallel zu den Gräben, eine Breite und eine Dicke definiert sind,
- Auffüllen der ersten Gräben (25) mit Gateoxid (22),
- Ausbilden von zweiten Gräben (26) im Gateoxid, wobei die zweiten Gräben (26) bis zum Drainkontakt (3) reichen,
- Ausbilden von Nanodrähten (4) innerhalb der zweiten Gräben (26), wobei die Längsachsen der Gatebänder (5') im Wesentlichen senkrecht zu den Längsachsen der Nanodrähte (4) verlaufen, wobei in einem Graben (21) mehrere Nanodrähte (4) verlaufen, und die Breite der Gatebänder (5'), die parallel zu den Nanodrähten (4) definiert ist, größer ist als die Dicke,
- Ausbilden eines Source-Kontakts (2) auf der Oberseite der Schichtstruktur.

17. Verfahren nach Anspruch 16,
**dadurch gekennzeichnet,**
**dass** der Drainkontakt (3) aus Molybdän oder Tantal besteht bzw. diese Materialien enthält.

18. Verfahren nach Anspruch 17,
**dadurch gekennzeichnet,**
**dass** auf dem Molybdän oder Tantal vor Ausbilden der Schichtstruktur beziehungsweise vor Ausbilden der Nanodrähte ein Katalysator abgeschieden wird.

## Claims

1. Semiconductor power switch (1, 20, 30) having:
- a source contact (2),
- a drain contact (3),
- a semiconductor structure which is provided between the source contact (2) and the drain contact (3), and
- a gate (5) which can be used to control a current flow through the semiconductor structure between the source contact (2) and the drain contact (3),
- wherein the semiconductor structure has a plurality of nanowires (4) which are connected in parallel and are arranged in such a manner that each nanowire (4) forms an electrical connection between the source contact (2) and the drain contact (3),
**characterized in that**
the gate (5) is implemented in the form of a plurality of gate bands (5') which are each defined by a length, a width and a thickness, the nanowires (4) run within trenches (21) which are provided between the gate bands (5'), wherein the longitudinal axes of the gate bands (5'), parallel to the trenches (21), run essentially perpendicular to the longitudinal axes of the nanowires (4), wherein a plurality of nanowires (4) runs in a trench (21), and the width of the gate bands (5'), which is defined parallel to the nanowires (4), is larger than the thickness.

2. Semiconductor power switch (1, 20, 30) according to claim 1,
**characterized in that**
the gate bands (5') and/or trenches (21) are at an equal distance from one another.

3. Semiconductor power switch (1, 20, 30) according to claim 1 or 2,
**characterized in that**
tubes (24) are provided within the trenches (21), at least one nanowire (4) respectively running within said tubes (24).

4. Semiconductor power switch (1, 20, 30) according to any one of claims 1 to 3,
**characterized in that**
insulation layers (22) are provided between the trenches (21) and the gate bands (5').

5. Semiconductor power switch (1, 20, 30) according to any one of the preceding claims,
**characterized in that**
the nanowires (4) are insulated from one another.

6. Semiconductor power switch (1, 20, 30) according to any one of the preceding claims,
**characterized in that**
the nanowires (4) are at an equal distance from one another.

7. Semiconductor power switch (1, 20, 30) according to any one of claims 1 to 6,
**characterized in that**
the gate bands (5, 5') have a band width which is approximately 1/3 of the distance between the source contact (2) and the drain contact (3).

8. Semiconductor power switch (30) according to any one of claims 1 to 7,
**characterized in that**
each gate band (5') is split into a plurality of gate subbands (5") which are insulated from one another, the gate subbands (5") being arranged above one another and each being designed such that it can be driven individually.

9. Semiconductor power switch (30) according to claim 8,
**characterized in that**
the gate subbands (5") of a gate band (5') are at an equal distance from one another.

10. Semiconductor power switch (30) according to claim 9,
**characterized in that**
the vertical positions of the gate subbands (5") of a gate band (5') are shifted with respect to the vertical positions of the gate subbands (5") of an adjacent gate band (5').

11. Semiconductor power switch (1, 20, 30) according to any one of the preceding claims,
**characterized in that**
the nanowires (4) are semiconducting carbon nanotubes.

12. Semiconductor power switch (1, 20, 30) according to any one of the preceding claims,
**characterized in that**
the nanowires (4) contain
- silicon;
- germanium;
- at least one of the III-V semiconductors BN, BP, BAs, AlN, AlP, AlAs, AlSb, GaN, GaP, GaAs, GaSb, InN, InP, InAs, InSb;
- at least one of the II-VI semiconductors ZnO, ZnS, ZnSe, ZnTe, CdS, CdSe, CdTe, HgS, HgSe, HgTe, BeS, BeSe, BeTe, MgS, MgSe;
- at least one of the compounds GeS, GeSe, GeTe, SnS, SnSe, SnTe, PbO, PbS, PbSe, PbTe,
- at least one of the compounds CuF, CuCl, CuBr, Cul, AgF, AgCl, AgBr, AgI.

13. Semiconductor power switch (1, 20, 30) according to claim 11 or 12,
**characterized in that**
the nanowires (4) are p-doped or n-doped.

14. Semiconductor power switch (1, 20, 30) according to any one of the preceding claims,
**characterized in that**
the length of the nanowires (4) is ((0.2 µm) * (maximum value of the voltage (in V) which is applied to the semiconductor power switch)).

15. Semiconductor power switch according to any one of claims 8 to 13, in which each gate band (5') is split into a plurality of gate subbands (5") which are insulated from one another, the gate subbands (5") being arranged above one another and each being designed such that it can be driven individually,
**characterized in that**
in the blocked state, the potentials of the gate subbands (5") are selectable in such a manner that the bandgap structures of the nanowires assume an undulating shape.

16. Method for producing a semiconductor power switch, said method having the following steps of:
- forming a layer structure on a drain contact (3), said layer structure having a first insulation layer (7), a gate layer (5) which is arranged above the latter and a second insulation layer (8) which is arranged above the gate layer,
- forming trenches (21) in the layer structure, said trenches reaching as far as the drain contact (3),
- forming nanowires (4) within the trenches (21),
- forming a source contact (2) on the top side of the layer structure, wherein the method is
**characterized by**
the following steps of:
- forming first trenches (25) in the layer structure, wherein the gate layer (5) is implemented in the form of a plurality of gate bands (5') which are each defined by a length, parallel to the trenches, a width and a thickness,
- filling the first trenches (25) with gate oxide (22),
- forming second trenches (26) in the gate oxide, the second trenches (26) reaching as far as the drain contact (3),
- forming nanowires (4) within the second trenches (26), wherein the longitudinal axes of the gate bands (5') run essentially perpendicular to the longitudinal axes of the nanowires (4), wherein a plurality of nanowires (4) runs in a trench (21), and the width of the gate bands (5'), which is defined parallel to the nanowires (4), is larger than the thickness.
- forming a source contact (2) on the top side of the layer structure.

17. Method according to claim 16,
**characterized in that**
the drain contact (3) is composed of molybdenum or tantalum or contains these materials.

18. Method according to claim 17,
**characterized i n that**
a catalyst is deposited on the molybdenum or tantalum before the layer structure is formed or before the nanowires are formed.

## Revendications

1. Disjoncteur (1, 20, 30) à semi-conducteur comprenant :
- un contact (2) de source,
- un contact (3) de drain,
- une structure de semi-conducteur prévue entre le contact (2) de source et le contact (3) de drain, et
- une grille (5) par laquelle un flux de courant entre le contact (2) de source et le contact (3) de drain peut être commandé en passant à travers la structure de semi-conducteur,
- dans lequel la structure de semi-conducteur a plusieurs nanofils (4) qui sont montés en parallèle et qui sont disposées de manière à ce que chaque nanofil (4) forme une liaison électrique entre le contact (2) de source et le contact (3) de drain,
**caractérisé**
**en ce que** la grille (5) est réalisée sous la forme de plusieurs bandes (5') de grille, qui sont définies respectivement par une longueur, par une largeur et par une épaisseur, les nanofils (4) s'étendent à l'intérieur de sillons (21) qui sont prévus entre les bandes (5') de grille, les axes longitudinaux des bandes (5) de grille s'étendent parallèlement aux sillons sensiblement perpendiculairement aux axes longitudinaux des nanofils (4), dans lequel plusieurs nanofils (4) s'étendent dans un sillon (21) et la largeur des bandes (5') de grille qui est définie parallèlement aux nanofils (4), est plus grande que l'épaisseur.

2. Disjoncteur (1, 20, 30) à semi-conducteur suivant la revendication 1,
**caractérisé**
**en ce que** les bandes (5') de grille et/ou les sillons (1) sont équidistants les uns des autres.

3. Disjoncteur (1, 20, 30) à semi-conducteur suivant la revendication 1 ou 2,
**caractérisé**
**en ce que** à l'intérieur des sillons (21) sont prévus des tubes (24) à l'intérieur desquels s'étend respectivement au moins un nanofil (4).

4. Disjoncteur (1, 20, 30) à semi-conducteur suivant l'une des revendications 1 ou 3,
**caractérisé**
**en ce que** des couches (22) isolantes sont prévues entre les sillons (21) et les bandes (5') de grille.

5. Disjoncteur (1, 20, 30) à semi-conducteur suivant l'une des revendications précédentes,
**caractérisé**
**en ce que** les nanofils (4) sont isolés les uns par rapport aux autres.

6. Disjoncteur (1, 20, 30) à semi-conducteur suivant l'une des revendications précédentes,
**caractérisé**
**en ce que** les nanofils (4) sont à une distance uniforme les uns des autres.

7. Disjoncteur (1, 20, 30) à semi-conducteur suivant l'une des revendications 1 à 6,
**caractérisé**
**en ce que** les bandes (5, 5') de grille ont une largeur de bande qui correspond à peu près au tiers de la distance entre le contact (2) de source et le contact (3) de drain.

8. Disjoncteur (1, 20, 30) à semi-conducteur suivant l'une des revendications 1 à 7,
**caractérisé**
**en ce que** chaque bande (5') de grille est subdivisée en plusieurs sous-bandes (5") de grille isolées les unes par rapport aux autres, les sous-bandes (5") de grille étant disposées les unes au dessus des autres et étant conformées de manière à pouvoir être commandées respectivement individuellement.

9. Disjoncteur (1, 20, 30) à semi-conducteur suivant la revendication 8,
**caractérisé**
**en ce que** les sous bandes (5") de grille d'une bande (5') de grille sont équidistantes les unes des autres.

10. Disjoncteur (1, 20, 30) à semi-conducteur suivant la revendication 9,
**caractérisé**
**en ce que** les positions verticales des sous-bandes (5") de grille d'une bande (5') de grille sont décalées par rapport aux positions verticales des sous-bandes (5") de grille d'une bande (5') de grille voisine.

11. Disjoncteur (1, 20, 30) à semi-conducteur suivant l'une des revendications précédentes,
**caractérisé**
**en ce que** les nanofils (4) sont des nanotubes semi-conducteurs en carbone.

12. Disjoncteur (1, 20, 30) à semi-conducteur suivant l'une des revendications précédentes,
**caractérisé**
**en ce que** les nanofils (4) contiennent
- du silicium,
- du germanium,
- au moins l'un des semi-conducteurs III-V BN, BP, BAs, AlN, AlP, AlAs, AlSb, GaN, GaAs, GaSb, InN, InP, InAs, InSb ;
- au moins l'un des semi-conducteurs II-VI ZnO, ZnS, ZnSe, ZnTe, CdS, CdSe, CdTe, HgS, HgSe, HgTe, BeS, BeSe, BeTe, MgS, MgSe ;
- au moins l'un des composés GeS, GeSe, GeTe, SnS, SnSe, SnTe, PbO, PbS, PbSe, PbTe ;
- au moins l'un des composés CuF, CuCl, CuBr, Cul, AgF, AgCl, AgBr, AgI.

13. Disjoncteur (1, 20, 30) à semi-conducteur suivant la revendication 11 ou 12,
**caractérisé**
**en ce que** les nanofils (4) sont à dopage p ou à dopage n.

14. Disjoncteur (1, 20, 30) à semi-conducteur suivant l'une des revendications précédentes,
**caractérisé**
**en ce que** la longueur des nanofils (4) est égale à ((0,2 µm)* (valeur maximum de la tension s'appliquant au disjoncteur à semi-conducteur) (en V))).

15. Disjoncteur (1, 20, 30) à semi-conducteur suivant l'une des revendications 8 à 13, dans lequel chaque bande (5') de grille est subdivisée en plusieurs sous-bandes (5") de grille isolées les unes des autres, les sous bandes (5") de grille étant disposées les unes au dessus des autres étant conformées de manière à pouvoir être commandées respectivement individuellement,
**caractérisé en ce que** à l'état bloqué les potentiels des sous--bandes (5") de grille peuvent être choisis de manière à ce que les structures de bande interdite des nanofils prennent, une forme ondulée.

16. Procédé de fabrication d'un disjoncteur à semi-conducteur comprenant les stades suivants :
- on forme une structure stratifiée sur un contact (3) de drain qui a une première couche (7) isolante, une couche (5) de grille disposée au dessus et une deuxième couche (8) isolante disposée au dessus de la couche de grille,
- on forme dans la structure stratifiée des sillons (21) qui vont jusqu'au contact (3) de drain,
- on forme des nanofils (4) à l'intérieur des sillons (21),
- on forme un contact (2) de source sur le côté supérieur de la structure stratifiée le procédé étant **caractérisé par** les stades suivants :
- on forme des premiers sillons (25) dans la structure stratifiée de manière à réaliser la couche (5) de grille sous la forme de plusieurs bandes (5') de grille qui sont définies respectivement par une longueur parallèlement aux sillons, une largeur et une épaisseur,
- on rempli les premiers sillons (25) d'oxyde (22) de grille,
- on forme des deuxièmes sillons (26) dans l'oxyde de grille, les deuxièmes sillons (26) allant jusqu'au contact (3) de drain,
- on forme des nanofils (4) à l'intérieur des deuxièmes sillons (26), les axes longitudinaux des bandes (5') de grille étant sensiblement perpendiculaires aux axes longitudinaux des nanofils (4), dans lequel dans un sillon (21) s'étendent plusieurs nanofils (4) et la largeur des bandes (5') de grille, qui est définie parallèlement aux nanofils (4), est plus grande que l'épaisseur,
- on forme un contact (2) de source du côté supérieur de la structure stratifiée.

17. Procédé suivant la revendication 16,
**caractérisé en ce que** le contact (3) de drain est en molybdène ou en tantale ou contient ces matériaux.

18. Procédé suivant la revendication 17,
**caractérisé en ce que** sur le molybdène ou le tantale on dépose un catalyseur, avant la formation de la structure stratifiée ou avant la formation des nanofils.
